(19) Europäisches Patentamt
European Patent Office
Office européen des brevets

(11) **EP 2 012 244 A1**

(12) **EUROPEAN PATENT APPLICATION**

(43) Date of publication:
**07.01.2009 Bulletin 2009/02**

(51) Int Cl.:
*G06F 17/50* (2006.01)     *H01F 5/00* (2006.01)
*H01F 17/02* (2006.01)

(21) Application number: **07111899.6**

(22) Date of filing: **06.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Seiko Epson Corporation**
**Shinjuku-ku,**
**Tokyo 163-0811 (JP)**

(72) Inventors:
• **López Villegas, José María**
  **08028 Barcelona (ES)**
• **Tanaka, Kazuaki**
  **08190 Sant Cugat del Vallés, Barcelona (ES)**

(74) Representative: **Carpintero Lopez, Francisco**
**Herrero & Asociados, S.L.**
**Alcalá 35**
**28014 Madrid (ES)**

(54) **Method for designing compact size inductors and compact size inductor thereof**

(57)    The invention refers to a method for designing a compact size inductor, which inductor is a spiral of $N$ turns occupying a square area of DxD, $D$ being its outer dimension, and where $s$ is the turn-to-turn spacing, $d$ its inner dimension, $w$ is the constant strip-width; the compact size inductor having an equivalent inductance $L_{eq}$; the method comprising the following steps:

obtaining a dependency of the inductance value $L_{eq}$ on the minimum inductor's outer dimension $D_{min}$ and fitting a curve using a non-linear expression;

the resulting compact size inductor is obtained, for a given inductance value $L_{eq}$ and considering fixed minimum values of the turn-to-turn spacing $s_{min}$, the inner dimension $d_{min}$ and the constant strip-width $w_{min}$:

- obtaining a minimum outer dimension $D_{min}$ using said non-linear expression;
- filling a square of $D_{min}xD_{min}$ with as many turns as possible, starting from the outside inwards, taking into account the geometrical restriction defined by:

$$N = \text{int}[D_{min}, \, s_{min}, \, w_{min}, \, d_{min}].$$

FIG. 4

**Description**

Field of the invention

The present invention lies in the field of the design of RF integrated circuits, and more specifically in the design and optimization of spiral inductors fabricated on semiconductor substrates

The present invention can be applied in a wide diversity of fields, such as semiconductor radio-frequency integrated circuit for wireless or wire-line communication, high-speed optical communication

Background of the invention

Usually, integrated inductors are designed based on achieving high Quality factor (Q factor). There are several approaches to the modelling of inductors in this aspect that can be found in literature: "A complete physical frequency dependent lumped model for RF integrated inducts" J Sieiro et al in IEEE Radio Freq. Integrated Circuits Symp., 2001, pp 121-124, or "Systematic analysis and modelling of integrated inductors and transformers in RFIC design"YK Koutsoyannopoulos et al in IEEE Trans. Circuits Syst. ll, vol. 47, pp. 699-713, Aug. 2000.

However, in the design of integrated passive components for RF integrated circuits, the occupied area is a valuable factor not only for low cost purposes but also to reduce parasitic effects. Indeed, one of the major problems of on-chip inductors is large area occupation in the layout, which implies a waste of chip size and an increase on the cost of the resulting IC. So it is important that the resulting IC inductor occupies the smallest area possible

At present this designing or modelling factor is not being taken into account for RFIC inductor modelling: there seems to be no clear rule or aim at saving chip area. In fact, in the prior art designing techniques, the inductor layout design does not consider carefully geometrical parameters, such as number of turns, line width, line space, inner diameter, etc.

US patent US-6311145-B1 discloses a method for the design and optimization of inductors for RF circuits The method consists in the formulation of RF circuit designs as geometric programs, where the designer can specify a wide variety of specifications such as gain, bandwidth, noise, etc. The optimization method disclosed in this patent does not take into consideration the occupied area.

Also, patent US-6714112 discloses a silicon-based inductor with varying width-spacing between adjacent turns. The spacing between the turns of the inductor is larger near the inside in order to reduce both conductor eddy currents and the induced substrate current- The area occupied by the resulting inductor is not a factor considered in this patent

It is known that the inductance of an arbitrary spiral is a function of geometry, and accurate computations require the use of field solvers or Greenhouse's method. However, there are some known expressions for calculating the equivalent inductance value in terms of the geometrical parameters), e. g. "Simple Accurate Expressions for Planar Spiral Inductances" S. S, Mohan et al in IEEE Solid-State Circuits, Vol. 34, No. 10, October 1999

Summary of the invention

The invention refers to a method for designing a compact size inductor according to claim 1 and to a compact size inductor according to claim 6. Preferred embodiments of the method are defined in the dependent claims.

The present invention aims at generating an optimized RF integrated inductor, based on the criterion of minimizing area consumption. According to the present invention, the wasting design area (wafer) space can be considerably reduced.

It is thus an objective of the present invention to find, during a design procedure, the most compact sized inductor geometry for a given inductance value,

The present invention prioritizes the criterion of minimizing area consumption, but at the same time enhancing the Q factor of the resulting inductor: for specific preestablished or given requirements relating to equivalent inductance, the compact size inductor obtained with the design method of the present invention is optimized from the point of view of area consumption. That is, it achieves the most appreciated inductor parameters from the designer's point of view, in area consumption and then Q factor

A first aspect the invention refers to a method for designing a compact size inductor, which compact size inductor is a spiral of $N$ turns occupying a square area of $DxD$, $D$ being its outer dimension, and where s is the turn-to-turn spacing, d its inner dimension, w is the constant strip-width; the compact size inductor having an equivalent inductance $L_{eq}$; the method comprising the following steps for a predefined frequency range:

- defining the outer dimension $D$ as a function which is only dependent on geometrical parameters of the inductor:

$$D = f(N, s, w, d);$$

- fixing the turn-to-turn spacing *s* and the constant strip-width *w* to a minimum permitted by design rules, whereby the outer dimension is a function dependent on the inner dimension *d* and the number of turns *N*:

$$D_{min} = f(N, s_{min}, w_{min}, d) \equiv D(N, d);$$

- defining a set of target equivalent inductance values $\{L_{eq}^1, L_{eq}^2, ... , L_{eq}^i\}$;
- for each target equivalent inductance value $L_{eq}^i$, preparing inductor layouts with a predefined quantity $k^i$ of discrete values $N_k^i$ of the number of turns *N*;

- carrying out simulations for each of said $\sum_i k^i$ prepared inductor layouts varying the inner dimension d during each simulation, in order to derive an inductor with the target equivalent inductance value $L_{eq}^i$;
- obtaining a set of minimum inductors $\{Ind^1, Ind^2, ., Ind^i\}$, by identifying in said simulated inductor layouts, for each target equivalent inductance value $L_{eq}^i$, the inductor layout with the smallest outer dimension *D*;
- obtaining a minimum size boundary by fitting a curve to said set of minimum inductors $\{Ind^1, Ind^2, Ind^3, ...\}$ using a non-linear expression;
the resulting compact size inductor is obtained, for a given inductance value $L_{eq}$ and considering the fixed minimum values of the turn-to-turn spacing $S_{min}$ and the constant strip-width $W_{min}$:
- obtaining a minimum outer dimension $D_{min}$ using said non-linear expression;
- filling a square of $D_{min} x D_{min}$ with as many turns as possible, starting from the outside inwards, taking into account the geometrical restriction defined by:

$$N = int[D_{min}, s_{min}, w_{min}, d_{min}].$$

Design rules are a series of parameters (such as minimum line space, width, hole, etc.) provided by semiconductor manufacturers that enable the designer to verify the correctness of the physical layout design. Design rules are specific to a particular semiconductor manufacturing process. That is, the invention proposes a method for designing a compact size inductor that takes into account the geometrical parameters of the inductor, such as number of turns, line width, line spacing, inner diameter, etc. optimizing the area used by the inductor.

Preferably the minimum size boundary is defined by the following non-linear expression:

$$D_{min} = a \times \left( L_{eq} \right)^b,$$

where *a* and *b* are fitting parameters obtained by fitting the obtained set of minimum inductors $(Ind^1, Ind^2, Ind^3, ...)$.

According to a preferred embodiment of the method of the invention, the outer dimension of the inductor *D* is calculated as follows:

$$D = d + 2w + 2(N-1) * (w + s),$$

where *d*, *s* and *w* are a fixed to a constant value, which is the minimum allowed value according to design rules.

According to a preferred embodiment, the invention further comprises establishing a maximum permitted area, and establishing a design area from the minimum size defined by the minimum size boundary up to such the maximum permitted area. According to this preferred embodiment, a higher Q factor can be obtained if within such design area a larger area is selected.

The set of target equivalent inductance values $\{L_{eq}^1, L_{eq}^2, ..., L_{eq}^i\}$ can be defined or chosen at the designer's will or needs. Generally, the set can be defined according to the circuit specification of frequency range. For example, at an operating frequency of 2.4 GHz, it is sufficient with inductance values between 1 and 10 nH. At a lower frequency, for example some hundreds of MHz, it will be required to chose inductance values around 20 or 30 nH.

During each simulation the value of the number of turns is fixed to a value; and there is a predefined quantity $k^i$ or number of discrete values of the number of turns $N$, which quantity can be different for each target inductance value $L_{eq}^i$ And this predefined quantity $k^i$ of discrete values $N_k^i$ of the number of turns N for each target equivalent inductance value $L_{eq}^i$ can be predefined from a rough estimation of a mathematical calculation, since the equivalent inductance value $L_{eq}^i$ is proportional to the length of the inductor For certain $L_{eq}$ target values with two different values for $N$ is enough, and in some other cases three different $N$ may be needed. In general terms, simulating for three different values of $N$ is enough.

It is also possible to simulate, for a predefined quantity $k^i$ of discrete values $N_k^i$ of the number of turns $N$ and varying the inner dimension $d$ during each simulation, the dependency of the minimum outer dimension $D_{min}$ with the target equivalent inductance value $L_{eq}^i$, and also obtain a set of $N_k$, curves relating $L_{eq}$ to the outer dimension $D$. In this case, the step of obtaining a minimum size boundary comprises fitting an envelope to said set of $N_k$ curves, said envelope being defined by the non-linear expression:

$$D_{\min} = a \times \left( L_{eq} \right)^{b}.$$

The invention also refers to a compact size inductor designed according to the method defined herein-before.

Brief description of the drawings

To complete the description and in order to provide for a better understanding of the invention, a set of drawings is provided. Said drawings form an integral part of the description and illustrate preferred embodiments of the invention, which should not be interpreted as restricting the scope of the invention, but just as examples of how the invention can be embodied, The drawings comprise the following figures:

Figure 1 shows the geometry of an on-chip integrated inductor.
Figure 2 shows the step of preparing the inductor layouts for a target inductance value of $L_{eq}$=1nH and N=3 and 4, and with $d$ as the variable parameter during the simulations (steps 2 and 3).
Figure 3 shows two optimized inductor layouts for 1nH and N=3 and 4 turns.
Figure 4 shows a set of simulations of the minimum outer dimension $D_{min}$ behaviour for every inductance value $L_{eq}$ in the frequency range of interest.
Figure 5 shows the fitting curve which represents the minimum outer dimension $D_{min}$ required to implement an inductor with a desired $L_{eq}$.

Detailed description of the preferred embodiments

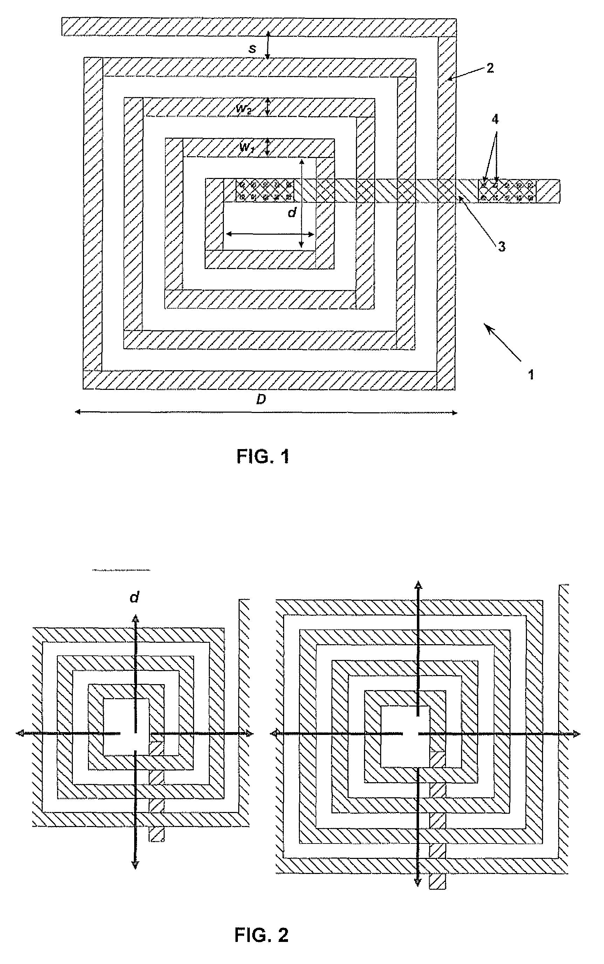

Reference will now be made in detail to a preferred embodiment of the method of the present invention, which aims at obtaining a compact size inductor, the latter being defined as an inductor which minimizes area consumption. With the method of the present invention, the resulting inductor is not necessarily optimized from the point of view of Q factor (electrical performance), but is compact from the geometrical point of view, filling the inductor coil up to the centre (as shown in figure 1).

Figure 1 shows the main geometrical parameters of a basic square inductor 1, with two metal levels on a semiconductor-based technology, top metal 2 and bridge metal 3, with the corresponding vias 4; the top metal usually presents major thickness. The main geometrical inductor parameters can be defined as follows: $N$, number of turns; $s$, turn-to-turn spacing; $d$, inner dimension; $D$, outer dimension, $w_i$, width of the $i^{th}$ turn of the spiral (i=1, ... N).

Other usual inductor geometries (i.e. circular or octagonal) are not to be discarded. However, the final occupied inductor area inside the device integration area will always be a squared area, independently of the intrinsic geometry of the structure The square geometry can fill better the vertices of the final area, presenting lower metal losses and hence better performances; otherwise, other geometries should be considered.

The following parameters are used to define the required specification of the inductor:

$L_{eq}$      Equivalent inductance of inductor.
$L_{DC}$      DC limit of the equivalent Inductance,

$L_{min}$ — Minimum value of the Equivalent Inductance.

$f_{Lmin}$ — Frequency at which the equivalent inductance shows its minimum value,

Q — Quality factor of inductor.

$Q_{max}$: — Maximum Quality factor

$f_{Qmax}$ — Frequency at which Quality factor shows its maximum value.

$R_{DC}$ — DC value of the series resistance.

SRF — Self Resonant Frequency: frequency at which the equivalent inductance and the Quality factor go to zero.

Once these parameters are considered, the Flat-BW of Flat Band Width may be defined, which is the frequency range at which the equivalent inductance values are within $L_{min}$ and $1.10*L_{min}$ (+/- 10%), for example.

The main objective of the present invention is to find the geometry of the most compact sized inductor for a given inductance value $L_{eq}$ during design.

First, "geometrical constraints" are considered; these constraints depend on the design rules or inductor parameters indicated before: turn-to-turn or line spacing s, line width w and inner dimension d, which are provided by semiconductor manufacturers and enable the designer to verify the correctness of the physical layout design A constant strip or line width w inductor is considered.

s and w are a fixed to a constant value, not variable during whole procedure, which is the minimum allowed value according to design rules. The inner dimension d is also a given value by the designer's requirements, for example, how many vias the designer wants to include in order to connect the top metal and bridge metal (Figure 1). The outer dimension of the inductor D can be calculated as follows:

$$D = d + 2w + 2(N\text{-}1) * (w + s). \qquad [1]$$

As the turn-to-turn spacing s and the constant line width w have been fixed to a minimum permitted by design rules, the outer dimension is a function only dependent on the number of turns N and of the inner dimension d:

$$D_{min} = f(N, s_{min}, w_{min}, d) \equiv D(N, d). \qquad [2]$$

The next step consists in finding the minimum outer dimension $D_{min}$ behaviour for each target inductance value, for example, 1 nH, 2 nH, ..., 9 nH, 10 nH, in the frequency range of interest, taking advantage of an electromagnetic field solver (e. g, a method-of-moments based simulator). These simulations take into account different number of turns N. As it will be explained further below, this set of simulations [$L_{eq}$, N] leads to a "minimum size boundary".

In order to carry out these simulations, a set of target inductance values is defined (step 1). Generally, this set of $L_{eq}$ can be defined according to the circuit specification of frequency range. For example, at an operating frequency of 2 4 GHz, it is sufficient with inductance values between 1 and 10 nH. At a lower frequency, for example some hundreds of MHz, it will be required to chose inductance values around 20 or 30 nH.

Then for each target equivalent inductance value $L_{eq}^i$, inductor layouts are prepared (step 2) with a predefined quantity $k^i$ of discrete values $N_k^i$ of the number of turns N. So during each simulation the value of the number of turns is fixed to a value; and there is a predefined quantity $k^i$ or number of discrete values of the number of turns N. This predefined quantity $k^i$ of discrete values $N_k^i$ of the number of turns N for each target equivalent inductance value $L_{eq}^i$ can be predefined from a rough estimation of a mathematical calculation, since the equivalent inductance value $L_{eq}^i$ is proportional to the length of the inductor.

For example: for $L_{eq}^1$=1nH, it is sufficient with $k^1$=2 and the discrete values are $N_1^1$=3 and $N_2^1$=4; this case is shown in figure 2, where two inductor layouts have been prepared with 3 and 4 turns for $L_{eq}^1$=1nH. Then for $L_{eq}^2$=2nH, $k^2$=3 and the discrete values of the number of turns are $N_1^2$=4, $N_2^2$=5 and $N_3^2$=6; ...; and for $L_{eq}^{10}$=10nH, $k^{10}$=2 and the discrete values of the number of turns are $N_1^{10}$=9, and $N_2^{10}$=10.

Once the inductor layouts have been prepared, simulations are carried out with an electromagnetic field simulator (by method-of-moments, finite element method, etc.), for the different number of turns (step 3). During this simulation the variable parameter is the inner dimension d (shown by the solid arrows in figure 2) -which implies a variation also in the total length of the inductor-, in order to obtain or derive the target inductance value $L_{eq}$ for each inductor (this step is also called optimization of $L_{eq}$).

Simulations are carried out for all the inductor layouts prepared in step 2.

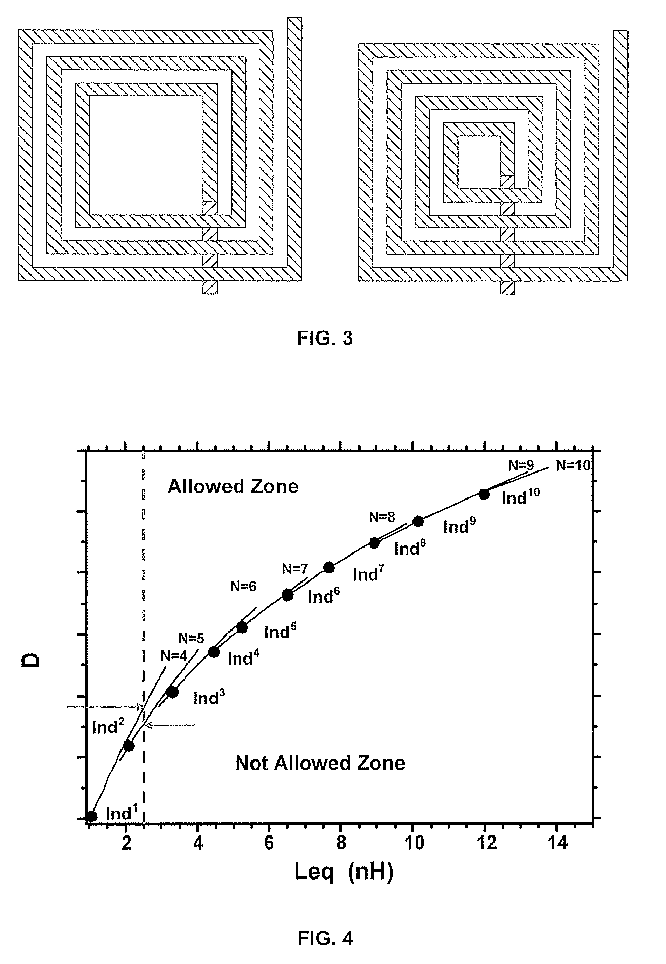

Once the optimization of $L_{eq}$ is finished, $k^i$ optimized inductor layouts are obtained and the resulting outer dimension D among then can be compared (step 4). Figure 3 shows the resulting optimized inductors for 1 nH with 3 and 4 turns It is clear that in order to derive the same $L_{eq}$ with different number of turns $N$, the inductor with the smaller number of turns (N=3 in this case) occupies a larger area (has a larger outer dimension $D$) than the inductor with a bigger $N$ (N=4 in this case). It would have also been possible to prepare the inductor layout for N=5 turns, and then check to see if the resulting optimized inductor is smaller -it obviously depends on design time-,but as indicated before, the designer knows that with 5 turns the corresponding inductor would be too long (with the consequent influence on $L_{eq}$).

Then, for each $L_{eq}{}^i$ the inductor with the smallest outer dimension $D$ is chosen (step 5).

So in this case, for $L_{eq}{}^1$=1nH, the minimum simulated inductor Ind[1] chosen is the one corresponding to 4 turns. And for the case of $L_{eq}{}^2$=2nH, the chosen inductor Ind[2] corresponds to 5 turns.

This way, after the previous step (step 5) a set of minimum inductors {Ind[1], Ind[2], .., Ind[i]} is obtained (step 6).

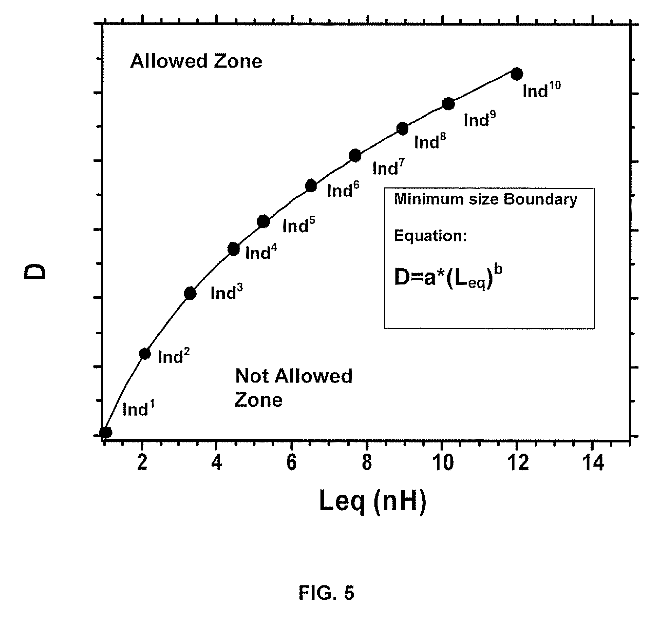

A minimum size boundary (see figure 5) is then obtained by fitting a curve to that set of minimum inductors {Ind[1], Ind[2], Ind[3], ...} using the following non-linear expression:

$$D_{min} = a \times \left(L_{eq}\right)^b \qquad\qquad [3].$$

Possible examples of valid values for a and b are a=100 and b=034, for $D_{min}$=100 um and $L_{eq}$=1 nH at a frequency of 2,5 GHz,

Once the minimum size boundary or fitting curve has been obtained, the most compact inductor geometry for a required or desired inductance value $L_{eq}$ can be obtained as follows:

The minimum outer dimension $D_{min}$ is obtained using the fitting equation [3], which defines the minimum size boundary.

A square area of $D_{min}$ x $D_{min}$ is filled with as many turns $N$ as possible, from the outside to the inside, taking into account the geometrical restrictions of inductor's line width and turn-to-turn spacing $w$ and $s$, respectively.

Then, the number of turns N of the resulting inductor is an integer of function of the parameters $D_{min}$, $s_{min}$, $w_{min}$, $d_{min}$

$$N = \text{int}\left[D_{min}, s_{min}, w_{min}, d_{min}\right]$$

Once the layout is generated, the inner dimension $d$ can be calculated considering expression [1] and also the new parameters $D_{min}$ and $N$. This calculus can be compared directly with the centre hole measurements in the layout to corroborate the results.

The solid lines in figure 4 correspond to the relationship between the outer dimension $D$ and the equivalent inductance $L_{eq}$ for different values of the number of turns $N$ (N=1, 2,..., 10). The dots in figure 4 indicate the location of the inductor structures (Ind[1], Ind[2], Ind[3], ... Ind[10]) which have been designed and obtained; these data have been obtained using electromagnetic simulation on a semiconductor substrate. In this example every inductance value has been calculated at an operating frequency of 2.5 GHz.

As it has also been explained before, for a given inductance value $L_{eq}$ it is possible to have more than one inductor implementation. An example of this is shown by the dashed line in figure 4, where for a given equivalent inductance value of 2 5 nH there are two possible inductor implementations: one of them corresponds to $N$=4 and the other to $N$=5 (both are indicated by arrows in this figure 4). The design algorithm is then able to select the implementation corresponding to the smaller outer dimension $D$.

There are two zones in the $D$ vs. $L_{eq}$ plot shown in figure 4: the "Allowed Zone" and the "Not Allowed Zone". In the "allowed zone", the pairs [$D$, $L_{eq}$] always correspond to realizable inductors. On the contrary, in the "not allowed zone", no inductors can be designed having the desired $L_{eq}$ and $D$ values. The boundary (the minimum size boundary) between both zones indicates the minimum $D$ required to implement an inductor with the desired $L_{eq}$ due to the design rules.

Figure 5 shows this minimum size boundary (the solid-line curve), which is a curve that has been fitted using the non-linear expression [3] or fitting equation indicated above, and also shown on the figure inset.

Similar fitting functions can be found in literature: "The Design of CMOS Radio Frequency Integrated Circuits, 2nd edition" Thomas H. Lee, Cambridge Univ. Press, pp. 136-144.

From the designer's point of view, there should be a criterion to establish the maximum allowed area (maximum outer dimension) for an inductor. Once this maximum is fixed, a design area is established: from the minimum size defined by the minimum size boundary up to the maximum allowed area; the area between these limits is the extra margin area to apply an optimization process: in principle, the larger the area, the better the improvements that may be achieved on Q factor.

As indicated before, the present invention relates to a method for designing compact size inductors. It is to be understood that the above disclosure is an exemplification of the principles of the invention and does not limit the invention to the illustrated embodiments.

**Claims**

**1.** Method for designing a compact size inductor (1), which compact size inductor is a spiral of $N$ turns occupying a square area of DxD, $D$ being its outer dimension, and where $s$ is the turn-to-turn spacing, $d$ its inner dimension, $w$ is the constant strip-width; the compact size inductor having an equivalent inductance $L_{eq}$; the method comprising the following steps for a predefined frequency range:

- defining the outer dimension $D$ as a function which is only dependent on geometrical parameters of the inductor:

$$D = f\left(N, s, w, d\right);$$

- fixing the turn-to-turn spacing $s$ and the constant strip-width $w$ to a minimum permitted by design rules, whereby the outer dimension is a function dependent on the inner dimension $d$ and the number of turns $N$:

$$D_{min} = f(N, s_{min}, w_{min}, d) \equiv D(N, d);$$

- defining a set of target equivalent inductance values $\{L_{eq}^1, L_{eq}^2, ... L_{eq}^i\}$;
- for each target equivalent inductance value $L_{eq}^i$, preparing inductor layouts with a predefined quantity $k^i$ of discrete values $N_k^i$ of the number of turns $N$;

- carrying out simulations for each of said $\sum_i k^i$ prepared inductor layouts varying the inner dimension $d$ during each simulation, in order to derive an inductor with the target equivalent inductance value $L_{eq}^1$;
- obtaining a set of minimum inductors $\{Ind^1, Ind^2, ..., Ind^i\}$, by identifying in said simulated inductor layouts, for each target equivalent inductance value $L_{eq}^i$, the inductor layout with the smallest outer dimension $D$;
- obtaining a minimum size boundary by fitting a curve to said set of minimum inductors $\{Ind^1$ $Ind^2$, $Ind^3$, ...$\}$ using a non-linear expression;

the resulting compact size inductor is obtained, for a given inductance value $L_{eq}$;

- obtaining a minimum outer dimension $D_{min}$ using said non-linear expression;
- filling a square of $D_{min}$x$D_{min}$ with as many turns as possible, starting from the outside inwards, taking into account the geometrical restriction defined by:

$$N = int[D_{min}, s_{min}, w_{min}, d_{min}].$$

**2.** Method according to claim 1, wherein said minimum size boundary is defined by the non-linear expression:

$$D_{\min} = a \times \left(L_{eq}\right)^b$$

where $a$ and $b$ are parameters obtained by fitting the obtained set of minimum inductors $\{Ind^1, Ind^2, Ind^3, \}$.

**3.** Method according to any of claims 1-2, wherein it further comprises establishing a maximum permitted area, and establishing a design area from the minimum size defined by the minimum size boundary up to such the maximum permitted area

**4.** Method according to any previous claim, wherein the predefined quantity $k^i$ of discrete values $N_k^i$ of the number of turns $N$ for each target equivalent inductance value $L_{eq}^i$ is defined as a prior estimation since the equivalent inductance value $L_{eq}^i$ is proportional to the length of the inductor.

**5.** Method according to any previous claim, wherein the set of target equivalent inductance values $\{L_{eq}^1, L_{eq}^2, ..., L_{eq}^i\}$ is defined according to the specification of frequency range

**6.** Compact size inductor (1) obtained according to the method defined in any of claims 1-6.

FIG. 1

FIG. 2

FIG. 3

FIG. 4

FIG. 5

**European Patent Office**

**DECLARATION**

which under Rule 63 of the European Patent Convention shall be considered, for the purposes of subsequent proceedings, as the European search report

Application Number

EP 07 11 1899

| The Search Division considers that the present application, does not comply with the provisions of the EPC to such an extent that it is not possible to carry out a meaningful search into the state of the art on the basis of all claims | CLASSIFICATION OF THE APPLICATION (IPC) |
|---|---|

Reason:

CLassification of the application (IPC)

INV.
G06F17/50
H01F5/00
H01F17/02

CLaims 1-5:
A meaningful search (R. 63 EPC2000) is not possible on the basis of claims 1-5 because these claims, as seen in the light of the whole of the description, are exclusively directed to a mathematical method. Applications exclusively directed to mathematical methods do not comply with the Convention insofar such claims are generally excluded from patentability under Article 52(2) to (3)(EPC2000) (cf. Guidelines B-III(3.11), B-VIII(1), EPC2000).
It is further pointed out that an invention in the meaning of Art. 52(1) must be of both a concrete and a technical character (Guidelines C-IV 2.1) and must have technical features (Rule 43(1), Guidelines C-IV1.2(ii) & C-III 2.1).
The application can be considered to have a technical character in relation to a technical field (R.42(1)a EPC and is concerned with a technical problem (R.42(1)c EPC.
However, the application being considered as a whole does not have technical features (R. 43(1) EPC). The application relies entirely on abstract, mathematical steps. Under the provisions of Art 52(2)(3) (cf. the Guidelines C-IV 2.2, first paragraph) purely abstract or mathematical methods are not patentable (cf. Guidelines C-IV 2.3.3).
Since the description does not provide any technical features, also a partial search (R.63 EPC) is not possible.
Claim 6:
1. By lack of any technical features, the inductor claimed in claim 6 is tantamount
-/--

| Place of search | Date | Examiner |
|---|---|---|
| Munich | 21 December 2007 | Winkelman, André |

EPO FORM 1504 (P04F37)

**European Patent Office**

**DECLARATION**

Application Number

which under Rule 63 of the European Patent Convention shall be considered, for the purposes of subsequent proceedings, as the European search report

EP 07 11 1899

| The Search Division considers that the present application, does not comply with the provisions of the EPC to such an extent that it is not possible to carry out a meaningful search into the state of the art on the basis of all claims | CLASSIFICATION OF THE APPLICATION (IPC) |
|---|---|

Reason:

to a desideratum (Guidelines C-III 4.10).
2. Moreover, the claimed inductor lacking technical features can not be distinguished from existing inductors (lack of technical features R. 43(1) EPC2000, lack of clarity Art. 84 EPC2000). Thus no novelty (Art. 54(1) EPC2000). Also here a meaningfull search, in the sense of the application complying with the Convention (R. 63 EPC) is not possible.

The applicant's attention is drawn to the fact that a search may be carried out during examination following a declaration of no search under Rule 63 EPC, should the problems which led to the declaration being issued be overcome (see EPC Guideline C-VI, 8.2).
-----

| Place of search | Date | Examiner |
|---|---|---|
| Munich | 21 December 2007 | Winkelman, André |

EPO FORM 1504 (P04F37)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6311145 B1
- US 6714112 B

**Non-patent literature cited in the description**

- **J SIEIRO et al.** A complete physical frequency dependent lumped model for RF integrated inducts. *IEEE Radio Freq. Integrated Circuits Symp.,* 2001, 121-124
- **YK KOUTSOYANNOPOULOS et al.** Systematic analysis and modelling of integrated inductors and transformers in RFIC design. *IEEE Trans. Circuits Syst. II,* August 2000, vol. 47, 699-713
- **S. S, MOHAN et al.** Simple Accurate Expressions for Planar Spiral Inductances. *IEEE Solid-State Circuits,* October 1999, vol. 34 (10
- **THOMAS H. LEE.** The Design of CMOS Radio Frequency Integrated Circuits. Cambridge Univ. Press, 136-144